# EUROPEAN PATENT APPLICATION

(11) **EP 4 811 110 A1**
(43) Date of publication of application: **23.09.2026**
(21) Application number: 26165047.7
(22) Date of filing: 16.03.2026
(51) Int. Cl.: G06F 7/58

(54) **APPARATUS AND METHOD FOR CONTROLLING P-BIT CELL**

(30) Priority: 19.03.2025 KR 20250035377; 12.03.2026 KR 20260044699
(71) Applicant: Electronics and Telecommunications Research Institute, Daejeon 34129 (KR)
(72) Inventor: IM, Jong-Pil, Daejeon 34129 (KR); PARK, Jae-Seoung, Daejeon 34129 (KR); PARK, Jeong-Woo, Daejeon 34129 (KR); SUH, Dong-Woo, Daejeon 34129 (KR); SONG, Han-Chan, Daejeon 34129 (KR); YU, Eui-Sang, Daejeon 34129 (KR); LEE, Wang-Joo, Daejeon 34129 (KR)
(74) Representative: Betten & Resch

(57) **Abstract**

Disclosed herein is an apparatus and method for controlling a probabilistic-bit (p-bit) cell. In the method, the p-bit cell includes a probabilistic element whose resistive state changes probabilistically, a transistor connected in series with the probabilistic element and configured to control an input current flowing through the probabilistic element in response to an input voltage, a resistance unit connected in series with the transistor, and a comparison circuit configured to generate an output signal by comparing a node voltage formed at a junction node between the probabilistic element and the transistor with a reference voltage, and the method may include variably setting the reference voltage applied to the comparison circuit such that an input current range in which probabilistic operation is performed varies.

## Description

### BACKGROUND OF THE INVENTION

### 1. Technical Field

The disclosed embodiment relates to technology for improving the performance of a probabilistic bit (p-bit) unit cell.

### 2. Description of the Related Art

Computing technologies may be broadly classified into digital bits, probabilistic bits (p-bits), and quantum bits (q-bits).

A digital bit, which is a fundamental computational unit of a classical computer, has only two discrete states, 0 and 1, and is widely used in most electronic devices, such as smartphones, personal computers (PCs), servers, and the like. These digital bits operate deterministically, always produce the same output for the same input, and process data through logic operations such as AND, OR, and NOT.

Also, digital bits have the advantage of being robust against errors and operating stably even in electromagnetically noisy environments. Furthermore, since digital bits have long served as an industry standard, their technical reliability has been proven, and they are advantageous in terms of production cost because existing semiconductor (CMOS) processes can be utilized without modification.

However, digital bits are inefficient for probabilistic operations such as random number generation and optimization problem solving and have limitations in handling problems such as machine learning, combinatorial optimization, and quantum-mechanical computations.

Meanwhile, a p-bit has discrete states of 0 or 1, similar to a digital bit, but exhibits stochastic characteristics in which the state changes according to a certain probability. That is, the state of a p-bit is determined to be 0 or 1 according to a probabilistic function, such as a sigmoid function, based on an input value, and due to this characteristic, p-bits are suitable for probability-based operations including machine learning, optimization problems, Monte Carlo methods, and sampling.

In particular, since p-bits can be implemented on classical hardware, they are easier to realize than quantum computing, which requires ultra-low-temperature environments, and can be integrated with existing semiconductor (CMOS) processes. Accordingly, p-bits are attracting attention for their use in the fields of Artificial Intelligence (AI) accelerators and specialized hardware for probabilistic computing.

However, since p-bits are not suitable for deterministic operations and are not fully compatible with existing digital computing architectures, a separate hardware structure for p-bit operations is required. Furthermore, since p-bits cannot utilize quantum properties such as superposition and entanglement, their computational capability is limited compared to q-bits.

A q-bit, which is a fundamental computational unit of a quantum computer, exists in a superposition state in which 0 and 1 coexist simultaneously, and enables parallel computations by utilizing entanglement among multiple q-bits.

Due to these characteristics, it is possible to rapidly process problems that are difficult to solve using existing computers, such as integer factorization and optimization problems, and to apply quantum algorithms such as Shor's algorithm and Grover's algorithm.

However, q-bits require ultra-low-temperature environments (several millikelvin (mK) or lower) and highly precise control techniques, which results in extremely high implementation costs. Also, due to stability issues caused by decoherence, significant constraints on industrial practicality exist to date.

As described above, a p-bit is a computational unit having intermediate characteristics between a digital bit and a quantum bit and has the advantage of being suitable for probabilistic computation while being implementable using classical semiconductor processes.

The performance of probabilistic computation of a p-bit unit cell is mainly determined by the characteristics of a magnetic tunnel junction (MTJ), which is a core element of the p-bit, but is also greatly affected by the structures of peripheral circuits constituting the unit cell, such as an inverter, a comparator, and an amplifier, and by control methods thereof.

In particular, when an input range optimized for probabilistic operations can be effectively controlled, not only the performance of the MTJ element but also the overall computational performance and reliability of a p-bit-based system may be further improved.

### SUMMARY OF THE INVENTION

An object of the disclosed embodiment is to provide hardware capable of effectively reducing computation time in an existing classical computing environment by performing a function similar to that of a q-bit in quantum computing, based on a probabilistic bit (p-bit) having probabilistic values.

Another object of the disclosed embodiment is to improve the probabilistic computational performance of a p-bit by enabling the input range of the p-bit to be expanded or narrowed and freely controlled in a desired direction and extent according to the purpose of computation.

An apparatus for controlling a p-bit cell according to an embodiment may include a probabilistic element whose resistance state changes probabilistically, a transistor connected in series with the probabilistic element and configured to control an input current flowing through the probabilistic element in response to an input voltage, a resistance unit connected in series with the transistor, a comparison circuit configured to generate an output signal by comparing a node voltage formed at a junction node between the probabilistic element and the transistor with a reference voltage, and a control unit configured to variably set the reference voltage applied to the comparison circuit such that an input current range (stochastic window) in which probabilistic operation is performed varies.

Here, the comparison circuit may be a hysteresis comparator having an upper threshold voltage and a lower threshold voltage.

Here, the control unit may control the hysteresis voltage range of the hysteresis comparator.

Here, the input current range may be defined as a region in which node voltage characteristics formed in low-resistance and high-resistance states of the probabilistic element intersect the upper and lower threshold voltages defining the hysteresis voltage range.

Here, the control unit may change the resistance value of the resistance unit such that the slope of the transition characteristic of the probabilistic element (slope of transition curve in the stochastic window) is adjusted depending on the variable input current range.

An apparatus for controlling a p-bit cell according to an embodiment may include a probabilistic element whose resistance state changes probabilistically, a first transistor connected in series with the probabilistic element and configured to control an input current flowing through the probabilistic element in response to an input voltage, a first resistance unit connected in series with the first transistor, a variable resistance unit, a second transistor connected in series with the variable resistance unit, a second resistance unit connected in series with the second transistor, an amplifier configured to generate an output signal by amplifying a difference between a first node voltage and a second node voltage, the first node voltage being formed at a junction node between the probabilistic element and the first transistor and the second node voltage being formed at a junction node between the variable resistance unit and the second transistor, and a control unit configured to change the second node voltage by changing the effective resistance value of the variable resistance unit such that an input current range (stochastic window) in which probabilistic operation is performed varies.

Here, the variable resistance unit may include a plurality of resistive elements and a switching element configured to selectively connect at least some of the plurality of resistive elements.

Here, the switching element may be implemented as a transistor switch, and the control unit may control the on/off state of the transistor switch to change the effective resistance value of the variable resistance unit.

Here, the second node voltage may have a voltage characteristic whose slope with respect to the input current varies depending on the effective resistance value of the variable resistance unit, and the input current range in which probabilistic operation is performed may be adjusted according to the voltage characteristic.

Here, the input current range may be defined as a region in which first node voltage characteristics formed in low-resistance and high-resistance states of the probabilistic element intersect a second node voltage characteristic formed by the variable resistance unit.

Here, the control unit may change the resistance values of the first and second resistance units such that the slope of the transition characteristic of the probabilistic element (slope of transition curve in the stochastic window) is adjusted depending on the variable input current range.

Here, the control unit may set initial values of the variable resistance unit, the first resistance unit, and the second resistance unit, calculate an energy value and a saturation ratio based on states of the probabilistic element through sampling, and repeatedly adjust the variable resistance unit, the first resistance unit, and the second resistance unit based on at least one of the calculated energy value, or the calculated saturation ratio, or a combination thereof.

Here, when the energy value decreases, the control unit may decrease the values of the first and second resistance units and then determine whether energy convergence is achieved.

Here, when the energy value does not decrease, the control unit may determine whether the saturation ratio is equal to or greater than a preset reference value, and when the saturation ratio is equal to or greater than the preset reference value, the control unit may increase the values of the first and second resistance units and determine whether energy convergence is achieved.

Here, when the saturation ratio is less than the preset reference value, whether input is biased may be determined, the variable resistance unit or the first and second resistance units may be adjusted depending on whether the input is biased, and whether energy convergence is achieved may be determined.

In a method for controlling a p-bit cell according to an embodiment, the p-bit cell may include a probabilistic element whose resistance state changes probabilistically, a transistor connected in series with the probabilistic element and configured to control an input current flowing through the probabilistic element in response to an input voltage, a resistance unit connected in series with the transistor, and a comparison circuit configured to generate an output signal by comparing a node voltage formed at a junction node between the probabilistic element and the transistor with a reference voltage, and the method may include variably setting the reference voltage applied to the comparison circuit such that an input current range (stochastic window) in which probabilistic operation is performed varies.

Here, the comparison circuit may be a hysteresis comparator having an upper threshold voltage and a lower threshold voltage.

Here, variably setting the reference voltage may include controlling the hysteresis voltage range of the hysteresis comparator.

Here, the input current range may be defined as a region in which node voltage characteristics formed in low-resistance and high-resistance states of the probabilistic element intersect the upper and lower threshold voltages defining the hysteresis voltage range.

Here, the p-bit cell may further include a variable resistance unit, a second transistor connected in series with the variable resistance unit, and a second resistance unit connected in series with the second transistor, and variably setting the reference voltage may include setting a second node voltage formed at a junction node between the second transistor and the variable resistance unit as the reference voltage such that the input current range in which probabilistic operation is performed varies by changing the effective resistance value of the variable resistance unit.

Here, the variable resistance unit may include a plurality of resistive elements and a switching element configured to selectively connect at least some of the plurality of resistive elements, and variably setting the reference voltage may include controlling the switching element.

Here, the switching element may be implemented as a transistor switch, and variably setting the reference voltage may include controlling the on/off state of the transistor switch to change the effective resistance value of the variable resistance unit.

Here, the second node voltage may have a voltage characteristic whose slope with respect to the input current varies depending on the effective resistance value of the variable resistance unit, and variably setting the reference voltage may include adjusting the input current range in which probabilistic operation is performed according to the voltage characteristic.

Here, the input current range may be defined as a region in which voltage characteristics of the node voltage formed in low-resistance and high-resistance states of the probabilistic element intersect a reference voltage characteristic formed by the variable resistance unit.

Here, the method for controlling a p-bit cell according to an embodiment may further include changing resistance values of the resistance unit and the second resistance unit such that the slope of the transition characteristic of the probabilistic element (slope of transition curve in the stochastic window) is adjusted depending on the variable input current range.

Here, the method for controlling a p-bit cell according to an embodiment may further include setting initial values of the variable resistance unit, the resistance unit, and the second resistance unit, calculating an energy value and a saturation ratio based on states of the probabilistic element through sampling, and repeatedly adjusting the variable resistance unit, the resistance unit, and the second resistance unit based on at least one of the calculated energy value, or the calculated saturation ratio, or a combination thereof until energy convergence is achieved.

Here, repeatedly adjusting the variable resistance unit, the resistance unit, and the second resistance unit may include decreasing the values of the resistance unit and the second resistance unit when the energy value decreases; and when the energy value does not decrease, determining whether the saturation ratio is equal to or greater than a preset reference value, increasing the values of the resistance unit and the second resistance unit when the saturation ratio is equal to or greater than the preset reference value, and determining whether input is biased when the saturation ratio is less than the preset reference value, and adjusting the variable resistance unit or adjusting the resistance unit and the second resistance unit depending on whether the input is biased.

### BRIEF DESCRIPTION OF THE DRAWINGS

The above and other objects, features, and advantages of the present disclosure will be more clearly understood from the following detailed description taken in conjunction with the accompanying drawings, in which:
FIG. 1 is a circuit diagram of a comparator-based p-bit cell;
FIG. 2 is a graph illustrating a characteristic in which an output probability of a p-bit cell changes depending on an input voltage;
FIG. 3 is a view illustrating output characteristics of a probabilistic bit at different input voltage levels in a time domain;
FIG. 4 is a circuit diagram of an inverter-based p-bit cell;
FIG. 5 is a circuit diagram of an amplifier-based p-bit cell;
FIG. 6 is a view for explaining an input range of a comparator-based p-bit cell;
FIG. 7 is a view for explaining an input range of an amplifier-based p-bit cell;
FIG. 8 is a circuit diagram of an apparatus for controlling a p-bit cell according to an embodiment;
FIG. 9 is a view for explaining the input range of a p-bit cell controlled by a hysteresis comparator according to an embodiment;
FIG. 10 is a circuit diagram of an apparatus for controlling a p-bit cell according to another embodiment;
FIG. 11 is an exemplary view illustrating an internal configuration of a variable resistance unit (Rₐᵥₑ) according to another embodiment;
FIG. 12 is a view for explaining the input range of a p-bit cell controlled by a variable resistance unit according to another embodiment;
FIG. 13 is a view for explaining a probabilistic operation method based on a Hopfield network;
FIG. 14 is a view for explaining a probabilistic operation method based on a Boltzmann machine;
FIG. 15 is a graph for explaining a simulated annealing effect applied to an embodiment;
FIG. 16 is a circuit diagram of an apparatus for controlling a comparator-based p-bit cell according to another embodiment;
FIG. 17 is a circuit diagram of an apparatus for controlling an amplifier-based p-bit cell according to another embodiment;
FIGS. 18 to 20 are views illustrating examples in which a simulated annealing effect is applied to an amplifier-based p-bit cell according to another embodiment; and
FIG. 21 is a flowchart for explaining the operation of applying simulated annealing to an apparatus for controlling an amplifier-based p-bit cell according to another embodiment.

### DESCRIPTION OF THE PREFERRED EMBODIMENTS

The advantages and features of the present disclosure and methods of achieving them will be apparent from the following exemplary embodiments to be described in more detail with reference to the accompanying drawings. However, it should be noted that the present disclosure is not limited to the following exemplary embodiments, and may be implemented in various forms. Accordingly, the exemplary embodiments are provided only to disclose the present disclosure and to let those skilled in the art know the category of the present disclosure, and the present disclosure is to be defined based only on the claims. The same reference numerals or the same reference designators denote the same elements throughout the specification.

It will be understood that, although the terms "first," "second," etc. may be used herein to describe various elements, these elements are not intended to be limited by these terms. These terms are only used to distinguish one element from another element. For example, a first element discussed below could be referred to as a second element without departing from the technical spirit of the present disclosure.

The terms used herein are for the purpose of describing particular embodiments only and are not intended to limit the present disclosure. As used herein, the singular forms are intended to include the plural forms as well, unless the context clearly indicates otherwise. It will be further understood that the terms "comprises," "comprising,", "includes" and/or "including," when used herein, specify the presence of stated features, integers, steps, operations, elements, and/or components, but do not preclude the presence or addition of one or more other features, integers, steps, operations, elements, components, and/or groups thereof.

Unless differently defined, all terms used herein, including technical or scientific terms, have the same meanings as terms generally understood by those skilled in the art to which the present disclosure pertains. Terms identical to those defined in generally used dictionaries should be interpreted as having meanings identical to contextual meanings of the related art, and are not to be interpreted as having ideal or excessively formal meanings unless they are definitively defined in the present specification.

A probabilistic bit (p-bit), whose value is determined probabilistically, is a computational unit that provides a computational concept similar to that of a q-bit in quantum computing while being implementable on classical hardware.

A p-bit generally follows a probability distribution between states 0 and 1 and performs probabilistic operations by changing its state probabilistically according to input conditions. Due to these characteristics, p-bits are actively being studied for potential use in various fields, including neural networks, optimization problems, machine learning, cryptography, and the like.

In particular, unlike quantum computers, p-bits do not require ultra-low-temperature environments or complex quantum control techniques, and can be integrated with existing semiconductor processes. Accordingly, p-bits may be utilized as hardware for accelerating probabilistic algorithms such as Boltzmann machines.

Such p-bits operate based on a classical stochastic model, and the output state thereof is determined by a probabilistic function, such as a sigmoid function, depending on an input signal. As a result, even under the same input conditions, the output is not deterministically fixed but probabilistically changes to either 0 or 1.

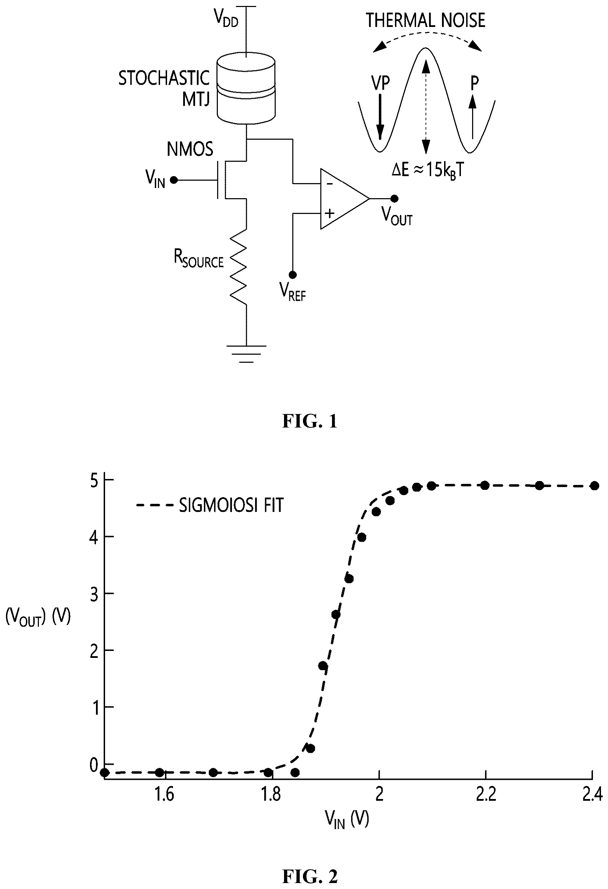

The operating principle of the p-bit will be described below with reference to FIGS. 1 to 3.

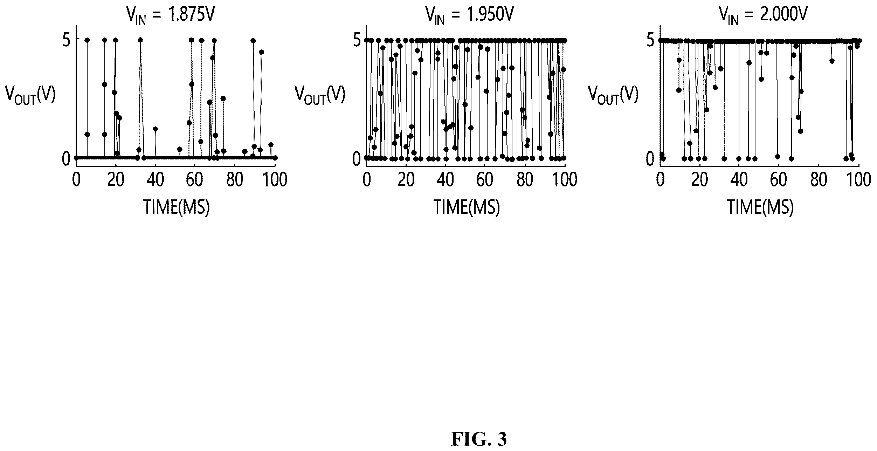

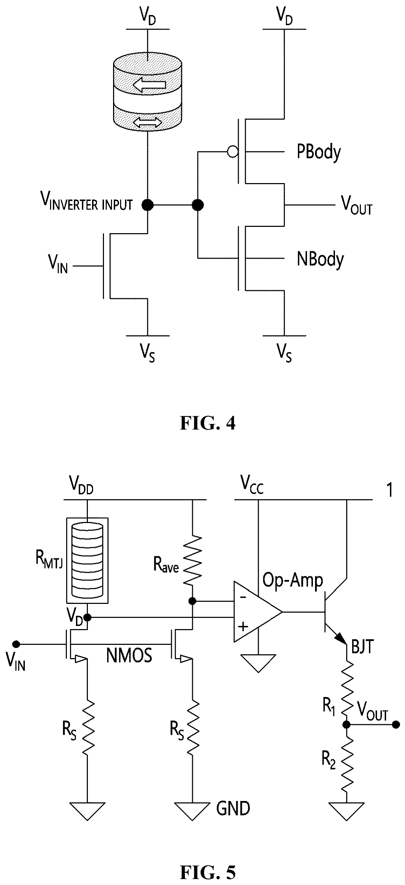

FIG. 1 is a circuit diagram of a comparator-based p-bit cell, FIG. 2 is a graph illustrating a characteristic in which the output probability of a p-bit cell varies depending on an input voltage, FIG. 3 is a view illustrating the output characteristics of a probabilistic bit at different input voltage levels in a time domain, FIG. 4 is a circuit diagram of an inverter-based p-bit cell, and FIG. 5 is a circuit diagram of an amplifier-based p-bit cell.

Referring to FIG. 1, the comparator-based p-bit cell includes a comparator that compares a reference voltage with a node voltage formed according to a change in the state of a magnetic tunnel junction (MTJ), whose resistance state varies probabilistically.

The magnetic tunnel junction (MTJ) probabilistically transitions between a low-resistance state P and a high-resistance state AP due to thermal noise. Such a change in the resistance state induces variation in the node voltage, thereby enabling an output signal to be determined probabilistically.

Accordingly, when the node voltage formed according to the resistance state of the MTJ is sufficiently lower or higher than the threshold of the comparator, that is, when the input voltage *Vᵢₙ* is low (e.g., 1.875 V) or high (e.g., 2.000 V), the output remains at 0 or 1, as illustrated in FIG. 3.

In contrast, when the node voltage formed according to a change in the resistance state of the MTJ is near the threshold of the comparator, that is, when the input voltage *Vᵢₙ* is in a threshold region (e.g., 1.950 V), the output repeatedly and probabilistically transitions between 0 and 1 over time.

Accordingly, the probabilistic operating characteristics of the p-bit vary depending on the level of the input voltage *Vᵢₙ.*

That is, as illustrated in FIG. 2, the probability that the output of the p-bit becomes 0 or 1 follows a sigmoid function as the input voltage changes. Accordingly, the p-bit does not operate deterministically in response to an input signal but has a probabilistic operating characteristic whose state is determined based on a probability function.

Meanwhile, a p-bit unit cell may be largely classified into three types depending on its implementation structure: an inverter type, a comparator type, and an amplifier type, which are illustrated in FIGS. 4, 1, and 5, respectively.

Features, advantages, and disadvantages of each structure of the p-bit unit cell may be summarized as shown in Table 1 below.

**[Table 1]**

| structure | advantages | disadvantages |
|---|---|---|
| inverter-based | - low-power implementation due to simple circuit design | - limited precision in probabilistic bit generation |
| | - easily integrated with CMOS technology | - sensitive to thermal noise, which may degrade stability |
| comparator-based | - generates reliable probabilistic output based on a threshold | - more complex circuit design than an inverter |
| | - enables more accurate probability control through comparison operations | - power consumption may increase |
| amplifier-based | - enables high-sensitivity probabilistic operation through signal amplification | - high power consumption |
| | | - additional calibration circuitry may be required |
| | - enables more precise control of analog probability distribution | |

That is, the inverter type illustrated in FIG. 4 has advantages of a simple circuit configuration and low power consumption but disadvantages of limited precision in probabilistic bit generation and low probabilistic computational performance due to sensitivity to thermal noise.

The comparator type illustrated in FIG. 1 has a structure in which an output of 0 or 1 is determined based on a threshold. Although it has greater circuit complexity and power consumption than the inverter type, a controllable threshold and improved noise immunity enable more stable probabilistic operation.

The amplifier type illustrated in FIG. 5 may perform high-sensitivity probabilistic operations by adjusting the gain of an amplifier and may more precisely control an analog probability distribution. However, power consumption and circuit area may be large, and additional calibration circuitry may be required.

The probabilistic computational performance of such a p-bit unit cell is mainly determined by the characteristics of the magnetic tunnel junction (MTJ), which is a core element of the p-bit, but may also be significantly affected by the structures of peripheral circuits constituting the unit cell, that is, selection of an inverter, a comparator, or an amplifier, and control methods thereof.

In particular, when an input range optimized for probabilistic computational performance, rather than a predetermined input range, can be effectively controlled, not only the performance of the MTJ element but also the overall computational performance and reliability of a p-bit-based system may be further improved.

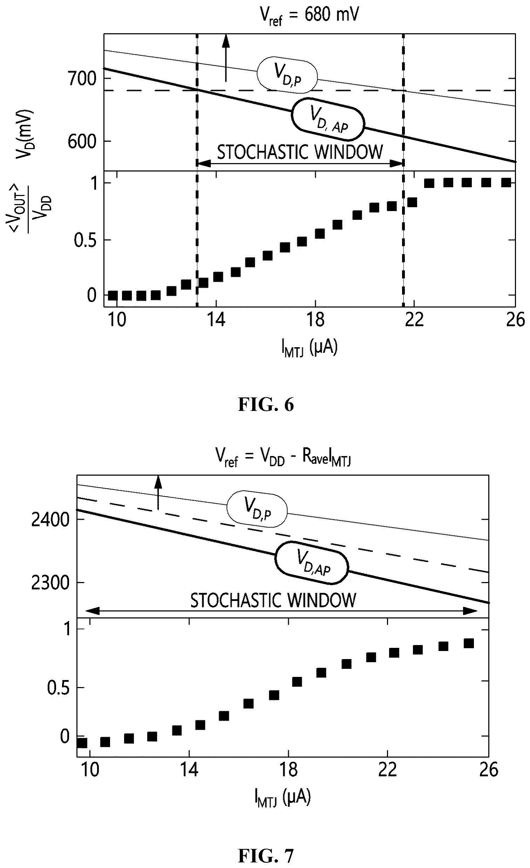

FIG. 6 is a view for explaining the input range of a comparator-based p-bit cell.

As illustrated in FIG. 6, *V_{d,P}* is a graph representing a change in the node voltage *V_{d}* with respect to the input current *I_{MTJ}* when the MTJ is in a low-resistance state P, and *V_{d,AP}* is a graph representing a voltage characteristic when the MTJ is in a high-resistance state AP.

Here, the probabilistic operation input range of a p-bit unit cell is defined as a region between points where the two voltage characteristic curves intersect the reference voltage *V_{ref}*. When the input falls outside this range, the output is determined to be a specific logical value of 0 or 1, rather than changing probabilistically.

In this regard, a prior document (titled "CMOS plus stochastic nanomagnets enabling heterogeneous computers for probabilistic inference and learning" and written by Nihal Sanjay Singh and Kerem Y. Camsari) has proposed a structure for expanding an input range of a p-bit unit cell.

In order to overcome the limitation of the input voltage range of the existing comparator-based p-bit structure illustrated in FIG. 6, the prior document proposes a method of expanding the input voltage range to a maximum extent in the amplifier-based p-bit structure such as that illustrated in FIG. 5, thereby expanding the range in which probabilistic operation is possible.

That is, FIG. 5 shows an amplifier-based p-bit cell having a structure in which a transistor and a resistor that have the same structures as the transistor and resistor R_{S} included in a path containing the MTJ are also applied to a path to which the input of the amplifier is connected, thereby minimizing process variation.

FIG. 7 is a view for explaining the input range of an amplifier-based p-bit cell.

Referring to FIG. 7, the input voltage range may be expanded as much as possible by setting the reference resistance *Rₐᵥₑ* to the median value between the low and high resistance values of the MTJ.

Although excessively expanding the input range allows probabilistic operation to be performed over a wide range, it increases the time required to search for a specific value and causes the output probability to become excessively uniform, which may make it difficult to perform desired optimal operation.

That is, the structure proposed in the prior document is also limited to merely expanding the input range in a fixed manner and has a limitation in that it does not provide an input range control function for selectively widening or narrowing the input range according to a computational purpose.

Accordingly, there is a need for an input range control method capable of adjusting the input range to a desired extent and position according to a computational purpose, rather than simply maximizing the input range.

As described above, the existing comparator-based and amplifier-based p-bit unit cells have limitations in optimizing probabilistic computational performance due to their fixed input ranges. Therefore, an embodiment aims to improve the efficiency and reliability of probabilistic operation by variably controlling the input range of a p-bit cell according to a computational purpose.

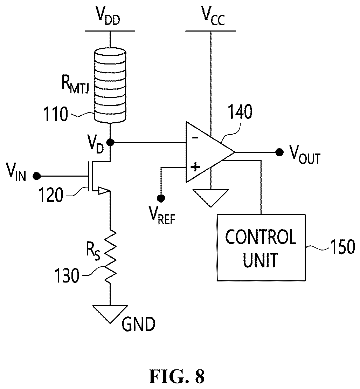

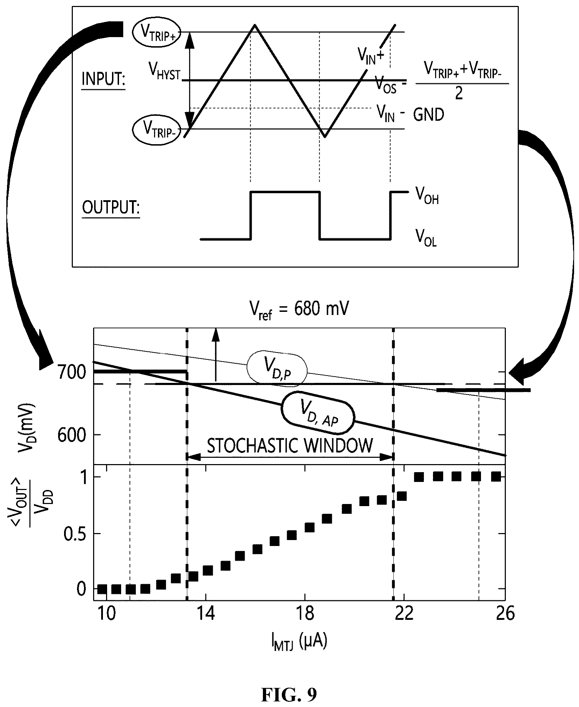

FIG. 8 is a circuit diagram of an apparatus for controlling a p-bit cell according to an embodiment, and FIG. 9 is a view for explaining the input range of a p-bit cell controlled by a hysteresis comparator according to an embodiment.

Referring to FIG. 8, the p-bit cell according to an embodiment may include a probabilistic element 110, a transistor 120, a resistance unit Rₛ 130, a comparison circuit 140, and a control unit 150. The probabilistic element 110 is an element whose resistance state changes probabilistically, and may include a magnetic tunnel junction (MTJ), as illustrated in FIG. 8.

Specifically, the MTJ probabilistically transitions between a low-resistance state P and a high-resistance state AP due to thermal noise, and accordingly, the resistance value of the MTJ changes probabilistically over time.

The probabilistic element 110 may include any of various elements having stochastic characteristics and performing operation similar to that of the MTJ, for example, a varistor, in addition to the MTJ.

The transistor 120 is connected in series with the probabilistic element 110 and is driven by the input voltage V_{IN} to control the magnitude of the input current I_{MTJ} flowing through the probabilistic element 110.

The resistance unit Rₛ 130 is connected in series with the transistor 120.

Also, a node voltage V_{D} is formed at a junction node between the probabilistic element 110 and the transistor 120 depending on the input current I_{MTJ}. The comparison circuit 140 compares the node voltage V_{D} formed at the junction node with a reference voltage to generate an output signal V_{OUT}.

In the structure of a conventional comparator-based p-bit cell, the output is determined based on a single reference voltage in the comparator corresponding to the comparison circuit 140, so there is a limitation in that the range of input voltage or input current (stochastic window), in which the probabilistic resistance transition of the MTJ is reflected to the probabilistic transition of the output, is limited to a specific region.

That is, when an input characteristic deviates from the single reference voltage, the output is fixed to a logical value of 0 or 1, and probabilistic operation of a p-bit cell is not performed.

Accordingly, in the embodiment, a comparator having a hysteresis characteristic is applied as the comparison circuit 140, unlike the conventional comparator-based structure using a fixed reference voltage.

That is, the hysteresis comparator 140 has an upper threshold voltage V_{TRIP+} and a lower threshold voltage V_{TRIP-}, and the hysteresis voltage range V_{HYST} is defined by the difference between these threshold voltages.

According to such a structure, the node voltage V_{D} is not evaluated based on a single reference voltage, and the output V_{OUT} transitions based on different threshold voltages depending on whether the node voltage V_{D} is increasing or decreasing.

The upper graph of FIG. 9 illustrates that the output V_{OUT} transitions when the node voltage passes through the upper threshold voltage V_{TRIP+} and the lower threshold voltage V_{TRIP-}, thereby forming the hysteresis voltage range V_{HYST}.

Referring to the lower graph of FIG. 9, the node voltage characteristic *V_{d,P}* formed when the MTJ is in a low-resistance state P and the node voltage characteristic *V_{d,AP}* formed when the MTJ is in a high-resistance state AP each vary with the MTJ current I_{MTJ}.

Here, the input current region where the two node voltage characteristic curves intersect the upper threshold voltage V_{TRIP+} and the lower threshold voltage V_{TRIP-} forms the input range of the p-bit cell.

That is, when an input voltage or input current falls within the input range, the probabilistic resistance transition of the MTJ and the threshold voltage characteristics of the hysteresis comparator are combined such that the output transitions between 0 and 1 probabilistically and repeatedly over time.

On the other hand, when the input deviates from the input range, the output remains at a specific logical value, and probabilistic operation of a p-bit cell is not performed.

Meanwhile, the control unit 150 may variably set the reference voltage applied to the comparison circuit 140 such that the input current range in which probabilistic operation is performed varies.

That is, the control unit 150 controls the hysteresis voltage range V_{HYST} of the hysteresis comparator, thereby adjusting the range of the input voltage or current in which the p-bit cell performs probabilistic operation.

Here, the input current range may be defined as a region in which the node voltage characteristics formed in the low-resistance and high-resistance states of the probabilistic element intersect the upper and lower threshold voltages defining the hysteresis voltage range.

Such a structure provides a characteristic that the input range may be set more flexibly compared to a conventional comparator-based p-bit cell having a single reference voltage.

That is, in the structure of the conventional comparator having a single reference voltage, probabilistic operation is possible only within a limited input current region in which the reference voltage intersects the node voltage characteristics of the MTJ. However, when a comparator having a hysteresis characteristic is applied as in the present embodiment, the voltage range between the upper threshold and the lower threshold allows probabilistic state transition, thereby effectively expanding a stochastic window, compared to the structure having a single threshold.

Although the above-described embodiment has been described with reference to an example in which a hysteresis comparator is applied, the present disclosure is not limited thereto. That is, the present disclosure may encompass all structures that control the input range of a p-bit cell by setting or changing the reference voltage of a comparison circuit in various ways.

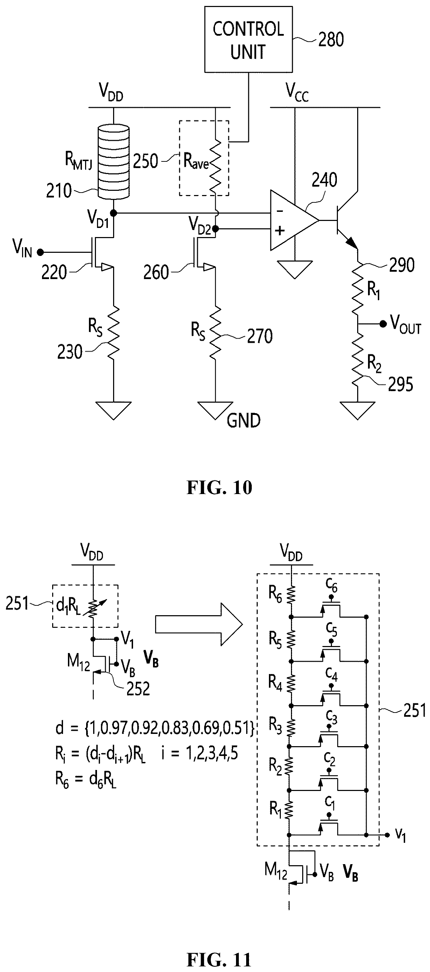

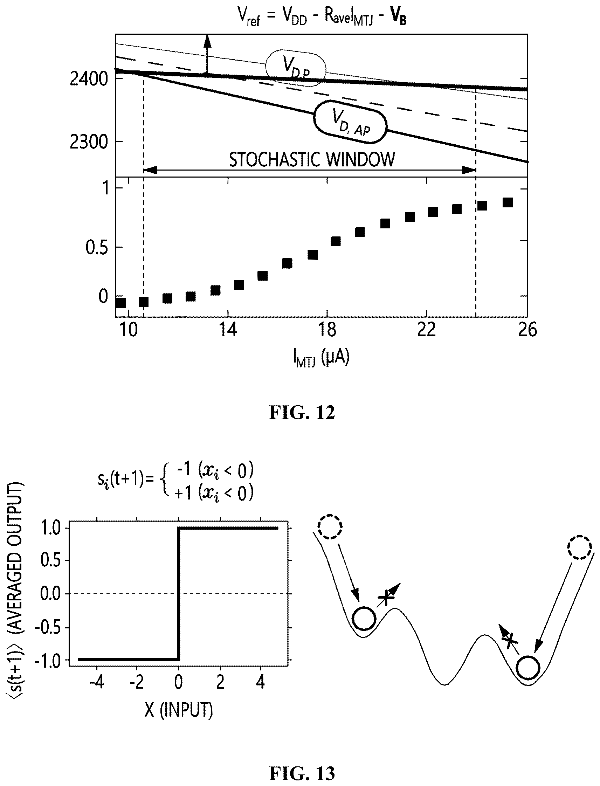

FIG. 10 is a circuit diagram of an apparatus for controlling a p-bit cell according to another embodiment, FIG. 11 is an exemplary view illustrating the internal configuration of a variable resistance unit Rₐᵥₑ according to another embodiment, and FIG. 12 is a view for explaining the input range of a p-bit cell controlled by a variable resistance unit according to another embodiment.

Another embodiment relates to a structure in which, instead of using a comparator as a comparison circuit, an amplifier is used to form and control a reference voltage characteristic, thereby setting the input range of a p-bit cell.

Referring to FIG. 10, the p-bit cell according to another embodiment may include a probabilistic element 210, a first transistor 220, a first resistance unit Rₛ 230, an amplifier 240, a variable resistance unit 250, a second transistor 260, a second resistance unit Rₛ 270, and a control unit 280.

That is, the p-bit cell according to another embodiment is configured such that the probabilistic element 210, the first transistor 220, and the first resistance unit Rₛ 230, which correspond to a first path, form a first node voltage V_{D1}, and the variable resistance unit Rₐᵥₑ 250, the second transistor 260, and the second resistance unit Rₛ 270, which are arranged in a second path corresponding to the first path, form a second node voltage V_{D2}.

The probabilistic element 210 is an element whose resistance state changes probabilistically, and may include a magnetic tunnel junction (MTJ), as illustrated in FIG. 10.

The first transistor 220 is connected in series with the probabilistic element 210 and is driven by the input voltage V_{IN} to control the magnitude of the input current I_{MTJ} flowing through the probabilistic element 210.

The first resistance unit Rₛ 230 is connected in series with the first transistor 220.

Also, the first node voltage V_{D1} may be formed at a junction node between the probabilistic element 210 and the first transistor 220 depending on the input current I_{MTJ}.

The variable resistance unit Rₐᵥₑ 250 may be an element whose effective resistance value changes in response to an external control signal. The second transistor 260 connected in series with the variable resistance unit 250 may be driven by the input voltage V_{IN}.

The second resistance unit 270 is connected in series with the second transistor 260.

Also, the second node voltage V_{D2} is formed at a junction node between the variable resistance unit 250 and the second transistor 260.

Here, the second transistor 260 and the second resistance unit 270, which are respectively identical to the first transistor 220 and the first resistance unit 230, are used such that process variation converges to zero so to have little effect.

The first node voltage V_{D1} and the second node voltage V_{D2} are applied to respective input terminals of the amplifier 240, and the amplifier 240 compares the two node voltages to generate an output signal V_{OUT}.

The output signal V_{OUT} may be formed at a predetermined output voltage level through a resistive divider (R₁ 290 and R₂ 295).

The control unit 280 changes the effective resistance value of the variable resistance unit 250, thereby controlling the second node voltage V_{D2}, which serves as the reference voltage, to change such that the input current range (stochastic window) in which probabilistic operation is performed varies.

Meanwhile, referring to FIG. 11, the variable resistance unit 250 may include a plurality of resistive elements 251 and a switching element 252 configured to selectively connect at least some of the plurality of resistive elements 251.

Here, the plurality of resistive elements 251 may include all devices capable of functioning as resistors, for example, transistors, in addition to general resistors.

Here, the switching element 252 may be implemented as a transistor switch, and the control unit 280 may change the effective resistance value of the variable resistance unit 250 by controlling the on/off state of the transistor switch.

That is, in another embodiment, unlike an existing fixed Rₐᵥₑ structure, a structure allowing the variable resistance unit 250 to be set to various values is applied, as illustrated in FIG. 12, thereby enabling more flexible control of the input current range of the p-bit cell.

Here, the second node voltage has a voltage characteristic whose slope with respect to the input current varies depending on the effective resistance value of the variable resistance unit 250, and the input current range in which probabilistic operation is performed may be adjusted according to the voltage characteristic.

Here, the input current range may be defined as a region in which first node voltage characteristics formed in the low-resistance and high-resistance states of the probabilistic element intersect a second node voltage characteristic formed by the variable resistance unit 250.

That is, referring to FIG. 12, in a coordinate system in which the input current I_{MTJ} is on the x-axis and the second node voltage V_{D2}, corresponding to the reference voltage, is on the y-axis, the effective resistance value Rₐᵥₑ of the variable resistance unit 250 acts as a factor determining the slope of the second node voltage characteristic, and V_{DD} - V_{B}, determined by the supply voltage V_{DD} and the control voltage V_{B} set by the control unit 280, may act as the intercept of the voltage characteristic.

Accordingly, the control unit 280 may control the intercept of the second node voltage characteristic by adjusting the value of V_{B} and may simultaneously adjust the slope of the voltage characteristic by changing the effective resistance value of the variable resistance unit 250.

As a result, the position and width of the region in which the first node voltage characteristics intersect the second node voltage characteristic change together, and consequently, the input current range in which probabilistic operation is performed may be set according to various conditions.

Although the other embodiment described above has been explained with reference to an example in which a specific resistance value or bias voltage is applied, the present disclosure is not limited thereto. That is, the present disclosure may encompass all structures that control the input range of a p-bit cell by setting or changing the reference voltage of a comparison circuit in various ways.

FIG. 13 is a view for explaining a probabilistic operation method based on a Hopfield network.

Referring to FIG. 13, the output of the Hopfield network has a step function form and is determined to be a discrete value depending on whether an input is positive or negative with respect to zero.

Also, the Hopfield network is configured such that state transitions are made only in a direction in which an energy function decreases. Accordingly, the network always converges toward lower energy, thereby reaching a stable state.

However, due to such deterministic characteristics, the network may converge to a specific local minimum and become trapped therein, thereby failing to find a global minimum, as shown in the right diagram of FIG. 13.

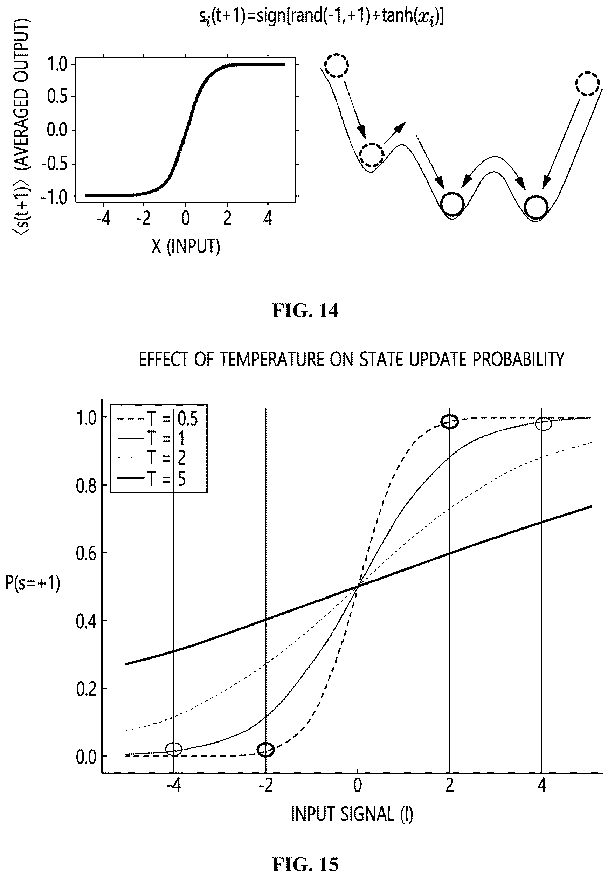

FIG. 14 is a view for explaining a probabilistic operation method based on a Boltzmann machine. Referring to FIG. 14, the output of the Boltzmann machine is determined based on a probability distribution in which the average output as a function of an input value follows the form of an S-shaped sigmoid curve. That is, unlike the step function of the Hopfield network illustrated in FIG. 13, the Boltzmann machine has continuous and probabilistic transition characteristics.

Also, although the Boltzmann machine tends to move toward lower energy states, temporary transitions to higher energy states are allowed because a random element is included.

Accordingly, the Boltzmann machine allows escape from a local minimum and increases the possibility of finding a global minimum, as shown in the right diagram of FIG. 14.

FIG. 15 is a graph for explaining a simulated annealing effect applied to an embodiment.

Referring to FIG. 15, sigmoid function forms corresponding to different temperature values are illustrated.

When the temperature is low, the slope of the sigmoid curve becomes very steep, and the sigmoid curve exhibits a shape similar to that of a step function. In this case, the state is selected almost deterministically depending on an input value with respect to a specific threshold, resulting in a decrease in probabilistic variation. In contrast, when the temperature is high, the slope of the sigmoid curve becomes more gradual, and the state is selected with different probabilities even for the same input value. Accordingly, a probabilistic characteristic is enhanced, and a search range is expanded.

Simulated annealing guarantees the possibility of escaping from a local minimum by applying a high temperature at an initial stage to allow transitions to higher energy states with a certain probability, and then gradually lowers the temperature to enable the system to converge to a stable state. Therefore, the temperature change acts as a key control factor for searching for a global minimum.

In the present disclosure, the above-described simulated annealing effect through temperature variation of a probabilistic element is implemented by controlling a resistance unit or transistor of a p-bit cell.

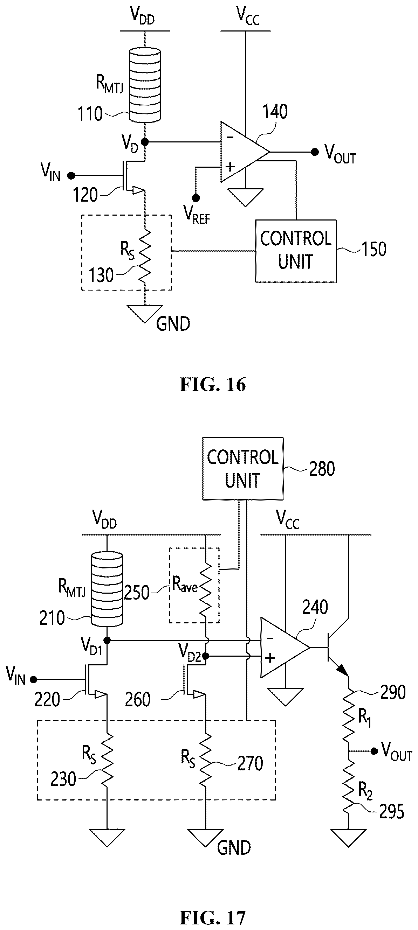

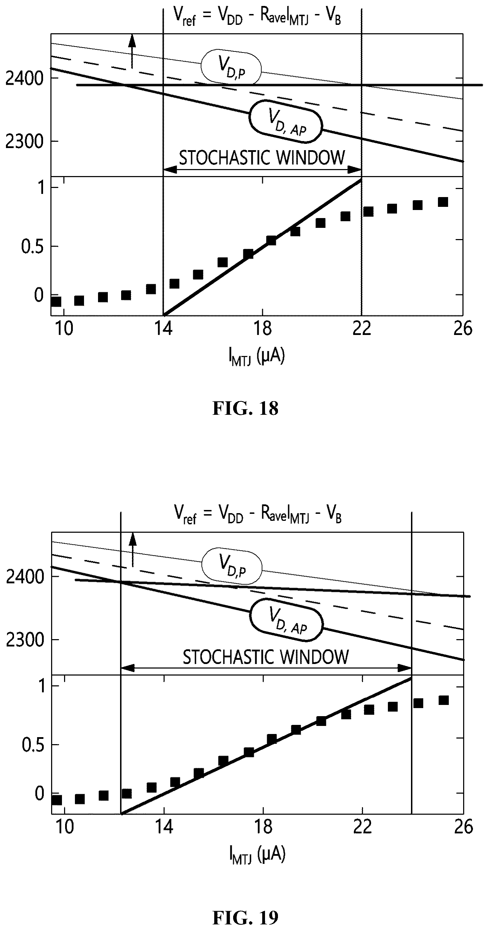

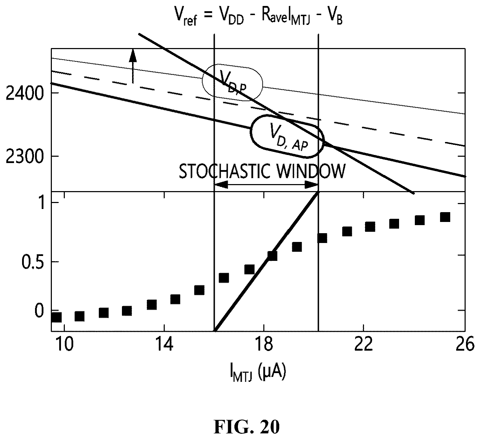

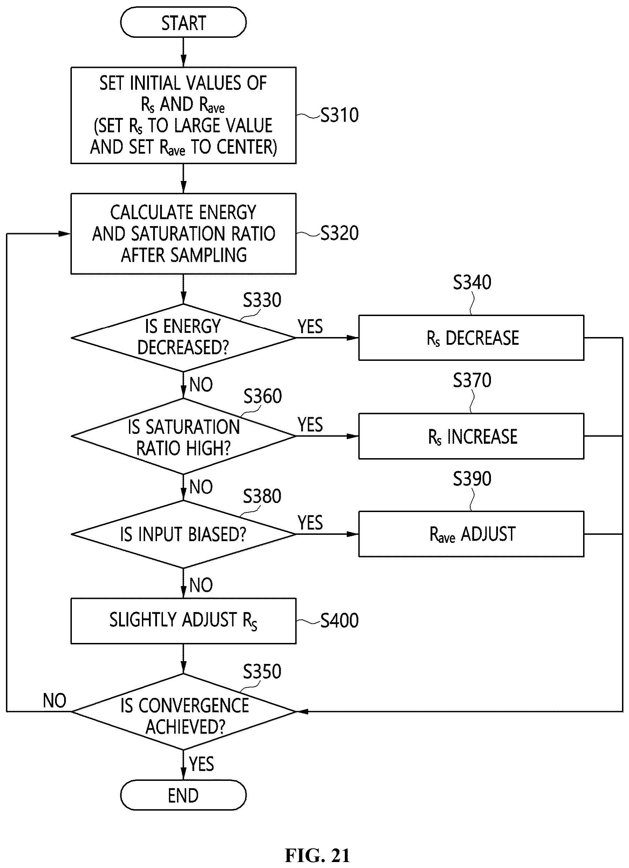

FIG. 16 is a circuit diagram of an apparatus for controlling a comparator-based p-bit cell according to another embodiment, FIG. 17 is a circuit diagram of an apparatus for controlling an amplifier-based p-bit cell according to another embodiment, FIGS. 18 to 20 are views illustrating examples in which a simulated annealing effect is applied in an amplifier-based p-bit cell according to another embodiment, and FIG. 21 is a flowchart for explaining an operation of applying simulated annealing in an apparatus for controlling an amplifier-based p-bit cell according to another embodiment.

Referring to FIG. 16, the apparatus for controlling a comparator-based p-bit cell according to another embodiment may implement a simulated annealing effect by adjusting the comparison circuit 140 and the resistance value of the resistance unit 130 through the control unit 150.

Here, the control unit 150 may adjust the resistance unit 130 according to the hysteresis voltage range.

That is, the control unit 150 may adjust the resistance value of the resistance unit 130 such that the slope of the transition characteristic of the probabilistic element (slope of transition curve in the stochastic window) is adjusted depending on the variable input current range.

Also, the transistor 120 may alternatively be adjusted to implement the simulated annealing effect. For example, the gain of the transistor 120 may be adjusted. That is, when the W/L of the transistor is adjusted, gm changes, whereby the input range and the slope of transition curve in the stochastic window may be changed.

Referring to FIG. 17, the apparatus for controlling an amplifier-based p-bit cell according to another embodiment may implement a simulated annealing effect in such a way that the control unit 280 adjusts the resistance values of the first resistance unit 230 and the second resistance unit 270, together with the effective resistance value of the variable resistance unit 250.

Here, the control unit 280 may adjust the first resistance unit 230 and the second resistance unit 270 depending on the effective resistance value of the variable resistance unit 250.

That is, the control unit 280 may adjust the resistance values of the first resistance unit 230 and the second resistance unit 270 such that the slope of the transition characteristic of the probabilistic element is adjusted depending on the variable input current range, as illustrated in FIGS. 18 to 20.

Also, in order to implement the simulated annealing effect, the first transistor 220 and the second transistor 260 may be adjusted. For example, the gain of the first transistor 220 and that of the second transistor 260 may be adjusted.

Referring to FIG. 21, the control unit 280 controls the variable resistance unit 250 to set the center of an input current range in which probability state transitions occur, and sets the resistance values of the first resistance unit 230 and the second resistance unit 270 to set the initial slope of the transition characteristic of the probabilistic element at step S310. Initially, the resistance values of the first resistance unit 230 and the second resistance unit 270 are set to large values such that the slope of the transition characteristic of the probabilistic element is adjusted to be more gradual.

Subsequently, the control unit 280 calculates an energy value and a saturation ratio based on states of the probabilistic element through sampling, and may repeatedly adjust the variable resistance unit 250, the first resistance unit 230, and the second resistance unit 270 depending on at least one of the calculated energy value, or the calculated saturation ratio, or a combination thereof at steps S320 to S400.

Specifically, when the energy value is lower than the previous energy value at step S330, the control unit 280 decreases the resistance values of the first resistance unit 230 and the second resistance unit 270 at step S340. That is, when the energy value is improved relative to the previous energy value, the slope of the transition characteristic of the probabilistic element may be adjusted to be steeper. Subsequently, the control unit 280 may terminate the process or proceed to step S320 to repeatedly perform operations starting from the sampling step, depending on the result of determining whether energy convergence is achieved at step S350.

Conversely, when it is determined at step S330 that the energy value is not lower than the previous energy value(when the energy value is not improved relative to the previous energy value), the control unit 280 determines whether the saturation ratio is equal to or greater than a preset reference value at step S360.

When it is determined at step S360 that the saturation ratio is equal to or greater than the reference value, the control unit 280 increases the resistance values of the first resistance unit 230 and the second resistance unit 270 at step S370. Subsequently, the control unit 280 terminates the process or proceeds to step S320 to repeatedly perform operations starting from the sampling step, depending on the result of determining whether energy convergence is achieved at step S350.

Conversely, when it is determined at step S360 that the saturation ratio is less than the reference value, the control unit 280 determines whether the input is biased at step S380.

When it is determined at step S380 that the input bias is detected, the control unit 280 corrects the center of the input current range by adjusting the variable resistance unit 250 at step S390.

Conversely, when it is determined at step S380 that no input bias is detected, the control unit 280 slightly adjusts the first resistance unit 230 and the second resistance unit 270 at step S400 and then proceeds to step S350.

In a method for controlling a p-bit cell according to an embodiment, the p-bit cell includes a probabilistic element whose resistance state changes probabilistically, a transistor connected in series with the probabilistic element and configured to control an input current flowing through the probabilistic element in response to an input voltage, a resistance unit connected in series with the transistor, and a comparison circuit configured to generate an output signal by comparing a node voltage formed at a junction node between the probabilistic element and the transistor with a reference voltage, and the method may include variably setting the reference voltage applied to the comparison circuit such that an input current range in which probabilistic operation is performed varies.

Here, the comparison circuit may be a hysteresis comparator having an upper threshold voltage and a lower threshold voltage.

Here, variably setting the reference voltage may include controlling the hysteresis voltage range of the hysteresis comparator.

Here, the input current range may be defined as a region in which node voltage characteristics formed in low-resistance and high-resistance states of the probabilistic element intersect the upper and lower threshold voltages defining the hysteresis voltage range.

Here, the p-bit cell may further include a variable resistance unit, a second transistor connected in series with the variable resistance unit, and a second resistance unit connected in series with the second transistor, and variably setting the reference voltage may include setting a second node voltage formed at a junction node between the variable resistance unit and the second transistor as the reference voltage.

Here, the variable resistance unit may include a plurality of resistive elements and a switching element configured to selectively connect at least some of the plurality of resistive elements, and variably setting the reference voltage may include controlling the switching element.

Here, the switching element may be implemented as a transistor switch, and variably setting the reference voltage may include controlling the on/off state of the transistor switch to change the effective resistance value of the variable resistance unit.

Here, the second node voltage may have a voltage characteristic whose slope with respect to the input current varies depending on the effective resistance value of the variable resistance unit, and variably setting the reference voltage may include adjusting the input current range in which probabilistic operation is performed according to the voltage characteristic.

Here, the input current range may be defined as a region in which node voltage characteristics formed in the low-resistance and high-resistance states of the probabilistic element intersect a reference voltage characteristic formed by the variable resistance unit.

Here, the method for controlling a p-bit cell according to an embodiment may further include changing the resistance values of the resistance unit and the second resistance unit such that the slope of the transition characteristic of the probabilistic element (slope of transition curve in the stochastic window) is adjusted depending on the variable input current range.

Here, the method for controlling a p-bit cell according to an embodiment may include setting initial values of the variable resistance unit, the resistance unit, and the second resistance unit, calculating an energy value and a saturation ratio based on states of the probabilistic element through sampling, and repeatedly adjusting the variable resistance unit, the resistance unit, and the second resistance unit based on at least one of the calculated energy value, or the calculated saturation ratio, or a combination thereof until energy convergence is achieved.

Here, repeatedly adjusting the variable resistance unit, the resistance unit, and the second resistance unit may include decreasing the values of the resistance unit and the second resistance unit when the energy value decreases; and, when the energy value does not decrease, determining whether the saturation ratio is equal to or greater than a preset reference value, increasing the values of the resistance unit and the second resistance unit when the saturation ratio is equal to or greater than the reference value, and determining whether the input is biased when the saturation ratio is less than the preset reference value, and adjusting the variable resistance unit or adjusting the resistance unit and the second resistance unit depending on whether the input is biased.

According to the disclosed embodiment, a function similar to that of a q-bit in quantum computing is performed based on a probabilistic bit (p-bit) having probabilistic values, whereby hardware capable of effectively reducing computation time in an existing classical computing environment may be provided.

Also, according to the disclosed embodiment, the probabilistic computational performance of a p-bit may be improved by enabling the input range of the p-bit to be expanded or narrowed and freely controlled in a desired direction and extent according to the purpose of computation.

Although embodiments of the present disclosure have been described with reference to the accompanying drawings, those skilled in the art will appreciate that the present disclosure may be practiced in other specific forms without changing the technical spirit or essential features of the present disclosure. Therefore, the embodiments described above are illustrative in all aspects and should not be understood as limiting the present disclosure.

## Claims

1. An apparatus for controlling a probabilistic bit (p-bit) cell, comprising:
a probabilistic element whose resistance state changes probabilistically;
a transistor connected in series with the probabilistic element and configured to control an input current flowing through the probabilistic element in response to an input voltage;
a resistance unit connected in series with the transistor;
a comparison circuit configured to generate an output signal by comparing a node voltage formed at a junction node between the probabilistic element and the transistor with a reference voltage; and
a control unit configured to variably set the reference voltage applied to the comparison circuit such that an input current range (stochastic window) in which probabilistic operation is performed varies.

2. The apparatus of claim 1, wherein
the comparison circuit is a hysteresis comparator having an upper threshold voltage and a lower threshold voltage,
the control unit controls a hysteresis voltage range of the hysteresis comparator, and
the input current range is defined as a region in which a hysteresis voltage between the upper threshold voltage and the lower threshold voltage intersects node voltage characteristics formed in low-resistance and high-resistance states of the probabilistic element.

3. An apparatus for controlling a probabilistic bit (p-bit) cell, comprising:
a probabilistic element whose resistance state changes probabilistically;
a first transistor connected in series with the probabilistic element and configured to control an input current flowing through the probabilistic element in response to an input voltage;
a first resistance unit connected in series with the first transistor;
a variable resistance unit;
a second transistor connected in series with the variable resistance unit;
a second resistance unit connected in series with the second transistor;
an amplifier configured to generate an output signal by amplifying a difference between a first node voltage and a second node voltage, the first node voltage being formed at a junction node between the probabilistic element and the first transistor and the second node voltage being formed at a junction node between the variable resistance unit and the second transistor; and
a control unit configured to change the second node voltage by changing an effective resistance value of the variable resistance unit such that an input current range (stochastic window) in which probabilistic operation is performed varies.

4. The apparatus of claim 3, wherein
the variable resistance unit includes a plurality of resistive elements and a switching element configured to selectively connect at least part of the plurality of resistive elements, and
the control unit controls an on/off state of the switching element to change the effective resistance value of the variable resistance unit.

5. The apparatus of claim 3, wherein the control unit changes resistance values of the first and second resistance units such that a slope of a transition characteristic of the probabilistic element (slope of transition curve in the stochastic window) is adjusted depending on the variable input current range.

6. The apparatus of claim 5, wherein the control unit sets initial values of the variable resistance unit, the first resistance unit, and the second resistance unit, calculates an energy value and a saturation ratio based on states of the probabilistic element through sampling, and repeatedly adjusts the variable resistance unit, the first resistance unit, and the second resistance unit based on at least one of the calculated energy value, or the calculated saturation ratio, or a combination thereof.

7. The apparatus of claim 5, wherein, when the energy value decreases, the control unit decreases the values of the first and second resistance units and then determines whether energy convergence is achieved.

8. The apparatus of claim 7, wherein, when the energy value does not decrease, the control unit determines whether the saturation ratio is equal to or greater than a preset reference value, and when the saturation ratio is equal to or greater than the preset reference value, the control unit increases the values of the first and second resistance units and determines whether energy convergence is achieved.

9. The apparatus of claim 8, wherein, when the saturation ratio is less than the preset reference value, whether input is biased is determined, the variable resistance unit is adjusted or the first and second resistance units are adjusted depending on whether the input is biased, and whether energy convergence is achieved is determined.

10. A method for controlling of a probabilistic-bit (p-bit) cell,
wherein the p-bit cell includes
a probabilistic element whose resistance state changes probabilistically;
a transistor connected in series with the probabilistic element and configured to control an input current flowing through the probabilistic element in response to an input voltage;
a resistance unit connected in series with the transistor; and
a comparison circuit configured to generate an output signal by comparing a node voltage formed at a junction node between the probabilistic element and the transistor with a reference voltage,
the method comprising:
variably setting the reference voltage applied to the comparison circuit such that an input current range (stochastic window) in which probabilistic operation is performed varies.

11. The method of claim 10, wherein
the comparison circuit is a hysteresis comparator having an upper threshold voltage and a lower threshold voltage,
variably setting the reference voltage comprises controlling a hysteresis voltage range of the hysteresis comparator, and
the input current range is defined as a region in which a hysteresis voltage between the upper threshold voltage and the lower threshold voltage intersects node voltage characteristics formed in low-resistance and high-resistance states of the probabilistic element.

12. The method of claim 10, wherein
the p-bit cell further includes
a variable resistance unit;
a second transistor connected in series with the variable resistance unit; and
a second resistance unit connected in series with the second transistor, and
variably setting the reference voltage comprises setting a second node voltage formed at a junction node between the second transistor and the variable resistance unit as the reference voltage such that the input current range in which probabilistic operation is performed varies by changing an effective resistance value of the variable resistance unit,
wherein the variable resistance unit includes
a plurality of resistive elements; and
a switching element configured to selectively connect at least part of the plurality of resistive elements, and
variably setting the reference voltage comprises controlling an on/off state of the switching element to change the effective resistance value of the variable resistance unit,
wherein the second node voltage has a voltage characteristic whose slope with respect to an input current varies depending on the effective resistance value of the variable resistance unit,
variably setting the reference voltage comprises adjusting the input current range in which probabilistic operation is performed according to the voltage characteristic, and
the input current range is defined as a region in which voltage characteristics of the node voltage formed in low-resistance and high-resistance states of the probabilistic element intersect a reference voltage characteristic formed by the variable resistance unit.

13. The method of claim 12, further comprising:
changing resistance values of the resistance unit and the second resistance unit such that a slope of a transition characteristic of the probabilistic element (slope of transition curve in the stochastic window) is adjusted depending on the variable input current range.

14. The method of claim 13, further comprising:
setting initial values of the variable resistance unit, the resistance unit, and the second resistance unit;
calculating an energy value and a saturation ratio based on states of the probabilistic element through sampling; and
repeatedly adjusting the variable resistance unit, the resistance unit, and the second resistance unit based on at least one of the calculated energy value, or the calculated saturation ratio, or a combination thereof until energy convergence is achieved.

15. The method of claim 14, wherein repeatedly adjusting the variable resistance unit, the resistance unit, and the second resistance unit comprises:
decreasing the values of the resistance unit and the second resistance unit when the energy value decreases; and
when the energy value does not decrease, determining whether the saturation ratio is equal to or greater than a preset reference value, increasing the values of the resistance unit and the second resistance unit when the saturation ratio is equal to or greater than the preset reference value, and determining whether input is biased when the saturation ratio is less than the preset reference value, and adjusting the variable resistance unit or adjusting the resistance unit and the second resistance unit depending on whether the input is biased.
